# FASCICULE DE BREVET EUROPEEN

(11) **EP 3 758 172 B1**
(45) Date de publication et mention de la délivrance du brevet: **19.10.2022**
(21) Numéro de dépôt: 20181579.2
(22) Date de dépôt: 23.06.2020
(51) Int. Cl.: H02B 1/01

(54) **CALE DE FIXATION ET ARMOIRE ÉLECTRIQUE COMPRENANT UNE TELLE CALE**
BEFESTIGUNGSKEIL UND SCHALTSCHRANK MIT EINEM SOLCHEN KEIL
FIXING WEDGE AND ELECTRICAL CABINET COMPRISING SUCH A WEDGE

(30) Priorité: 24.06.2019 FR 1906799
(43) Date de publication de la demande: 30.12.2020
(73) Titulaire: Schneider Electric Industries SAS, 92500 Rueil Malmaison (FR)
(72) Inventeur: GUINEBERT, Patrick, 38050 GRENOBLE CEDEX 09 (FR)
(74) Mandataire: Lavoix

(56) Documents cités:
- DE-U1- 29 505 255
- DE-U1- 29 505 255
- US-A- 1 038 664

## Description

La présente invention concerne une cale de fixation utilisée pour le montage d'accessoires dans une armoire électrique.

Il est connu de fabriquer des armoires électriques à partir d'une armature, le plus souvent métallique, sur laquelle sont rapportés des panneaux qui obturent les faces de cette armoire, tout en laissant une face libre pour la mise en place d'une porte articulée sur l'armature. Une façon connue de fixer un panneau sur l'armature d'une armoire électrique consiste à introduire des vis auto-taraudeuses dans des orifices ménagés dans ce panneau et à visser ces vis dans des alésages ménagés sur l'armature. Ces méthodes de fixation sont contraignantes à mettre en œuvre. Les orifices du panneau doivent être maintenus alignés en face des alésages de l'armature, et les vis introduites en même temps, ce qui est peu pratique. Lors du démontage des panneaux, notamment pour une opération de maintenance ou pour changer certains des équipements contenus dans l'armoire, les vis se retrouvent désolidarisées des panneaux et peuvent être perdues, ce qui est une source de perte de temps et d'argent.

Le document US-1 038 664-A décrit un clip métallique de forme recourbée, monté sur la tige d'un organe de fixation et agissant comme un ressort pour maintenir deux pièces, par exemple des panneaux, en appui l'une sur l'autre. Ce clip ne permet cependant pas de maintenir en place l'organe de fixation avant d'assembler les panneaux.

D'autre part, il est connu d'utiliser des traverses horizontales qui sont assemblées aux montants verticaux de l'armature, et de fixer à ces traverses des rails de montage au moyen de vis et de rondelles. Les vis et les rondelles prennent du temps à être mises en places lors du montage alors que le rail doit simultanément être maintenu en position, ce qui est peu pratique, et les vis et les rondelles peuvent être perdues lors du démontage, ce qui est là aussi une source de perte de temps et d'argent.

C'est à ces inconvénients qu'entend plus particulièrement remédier l'invention, en proposant une cale de fixation pour une armoire électrique, qui permette un positionnement aisé des pièces à assembler lors du montage et évite la perte des pièces lors du démontage.

À cet effet, l'invention concerne une cale de fixation destinée à recevoir un organe de fixation avec une protubérance radiale cylindrique, la cale étant réalisée en un matériau apte à se déformer élastiquement sous l'action d'un opérateur. Selon l'invention, la cale comprend une première paroi dans laquelle est ménagée une première encoche, la première encoche ayant une forme de U, une deuxième paroi dans laquelle est ménagée une deuxième encoche, la deuxième encoche ayant une forme de U, la première paroi et la deuxième paroi étant superposées et orthogonales à un axe principal de la cale, les première et deuxième encoches étant de formes similaires et alignées selon l'axe principal, chaque encoche comportant un bord interne définissant une embouchure et une base arrondie de forme circulaire centrée sur l'axe principal. La cale de fixation comprend, en outre, une cloison recourbée en forme de U, qui connecte la première paroi à la deuxième paroi en s'étendant parallèlement à l'axe principal et en retrait du bord interne des encoches, la cloison recourbée définissant un logement central aligné sur les première et deuxième encoches, alors que ledit logement central comporte une ouverture frontale et un fond, l'ouverture frontale ayant une largeur supérieure à la largeur de l'embouchure des encoches en U, et que ladite cloison recourbée comportant un chambrage ménagé dans l'épaisseur de la cloison recourbée qui élargit le logement central par rapport à l'ouverture frontale, le chambrage présentant une forme cylindrique coaxiale avec l'axe principal et de diamètre supérieur à la largeur de l'ouverture frontale et étant adapté pour accueillir, aux jeux d'assemblage près, la protubérance radiale cylindrique de l'organe de fixation.

Grâce à l'invention, la cale permet de pré-positionner l'organe de fixation par rapport à la pièce à assembler, et l'assemblage avec la cale se fait sans outil.

Selon des aspects avantageux mais non obligatoires de l'invention, une telle armoire peut incorporer une ou plusieurs des caractéristiques suivantes, prises selon toute combinaison techniquement admissible :
- Le logement central est délimité axialement suivant l'axe principal par des guides axiaux, qui sont évasés axialement en direction de l'ouverture frontale.
- Les guides axiaux sont raccordés à la face avant par des portions arrondies évasées axialement en direction de l'ouverture frontale.
- Les première et deuxième parois présentent des patins de centrage parallèles aux rebords internes et configurés pour coopérer sans jeu avec un rail de montage.
- L'ouverture frontale est apte à se déformer élastiquement selon une direction orthoradiale à l'axe principal.
- La cale de fixation est réalisée d'une seule pièce en un matériau synthétique, de préférence en polyamide non chargé.

L'invention concerne aussi une armoire électrique :
- L'armoire comprend au moins une cale de fixation selon l'une quelconque des revendications précédentes et un organe de fixation, l'organe de fixation comprenant une tige et une protubérance radiale cylindrique liée coaxialement à la tige, alors que la tige coopère avec la base arrondie d'au moins une des encoches en U de la première ou de la deuxième paroi, tandis que la protubérance radiale cylindrique coopère avec le logement central.
- L'armoire électrique comprend au moins un panneau avec une face externe, une face interne et un orifice reliant la face interne à la face externe, alors que l'organe de fixation est une vis, la vis comportant une tête et une tige filetée, la tête présentant un épaulement du côté de la tige, la protubérance radiale cylindrique étant un collet ménagé coaxialement sur la tige entre la tête et le bout de la tige, l'orifice du panneau présentant un diamètre supérieure au diamètre du collet et inférieur au diamètre de la tête de la vis, le panneau étant rapporté sur cette armature au moyen de la vis, la tête de la vis étant située du côté de la face externe du panneau, la cale étant en configuration assemblée sur le collet du côté de la face interne du panneau, et la tige de la vis traversant l'orifice du panneau et étant vissée dans l'armature.
- L'armature comprend au moins une traverse avec un alésage, un rail de montage avec un fond et deux parois latérales, le rail de montage définissant un côté externe et un côté interne, un deuxième orifice étant ménagé dans le fond, alors que l'organe de fixation est une vis comportant une tête avec un diamètre et une tige filetée, la protubérance radiale cylindrique de l'organe de fixation étant la tête de la vis, le deuxième orifice étant de diamètre supérieur au diamètre D102 de la tête de la vis, le rail de montage étant rapporté sur la traverse au moyen de la vis, dont la tige traverse le deuxième orifice du rail de montage et est vissée dans l'alésage de la traverse, la cale étant en configuration assemblée sur la tête de la vis, l'une des première ou deuxième parois de la cale étant en appui sur le côté interne du fond du rail de montage tandis que le coté externe du fond du rail est en appui sur la traverse, les patins de centrage coopérant avec les deux parois latérales du rail de montage.
- L'armoire électrique comprend au moins un panneau, rapporté sur cette armature et présentant une face interne, un rail de montage avec un fond et deux parois latérales, définissant un côté externe et un côté interne, un deuxième orifice étant ménagé dans le fond du rail de montage, alors que l'organe de fixation est un téton comprenant une tige, une embase et une tête, la protubérance radiale cylindrique de l'organe de fixation étant la tête du téton, l'embase du téton étant soudée à la face interne du panneau, le deuxième orifice étant de diamètre supérieur au diamètre de la tête du téton, la tige du téton traversant le deuxième orifice du rail de montage, la cale étant en configuration assemblée sur la tête du téton, l'une des première ou deuxième parois de la cale étant en appui sur le côté interne du fond du rail de montage tandis que le coté externe du fond du rail est en appui sur la face interne du panneau, les patins de centrage coopérant avec les deux parois latérales du rail de montage.

L'invention sera mieux comprise et d'autres avantages de celle-ci apparaîtront plus clairement à la lumière de la description qui va suivre d'un mode de réalisation d'une cale de fixation conforme à son principe et d'une armoire électrique comportant une telle cale, donnée uniquement à titre d'exemple et faite en référence aux dessins annexés, dans lesquels :
[Fig 1] la figure 1 est une vue en perspective d'une armoire électrique conforme à des modes de réalisation de l'invention ;
[Fig 2] la figure 2 est un écorché d'un détail de l'armoire de la figure 1, vu suivant la flèche II de la figure 1 ;
[Fig 3] la figure 3 est une vue en perspective du détail III à la figure 1 ;
[Fig 4] la figure 4 est une vue en perspective d'une cale selon des modes de réalisation de l'invention appartenant à l'armoire de la figure 1 ;
[Fig 5] la figure 5 est une coupe de la cale de la figure 4 suivant le plan V de la figure 4, et
[Fig 6] la figure 6 est une coupe de la cale de la figure 4 suivant le plan VI de la figure 4.

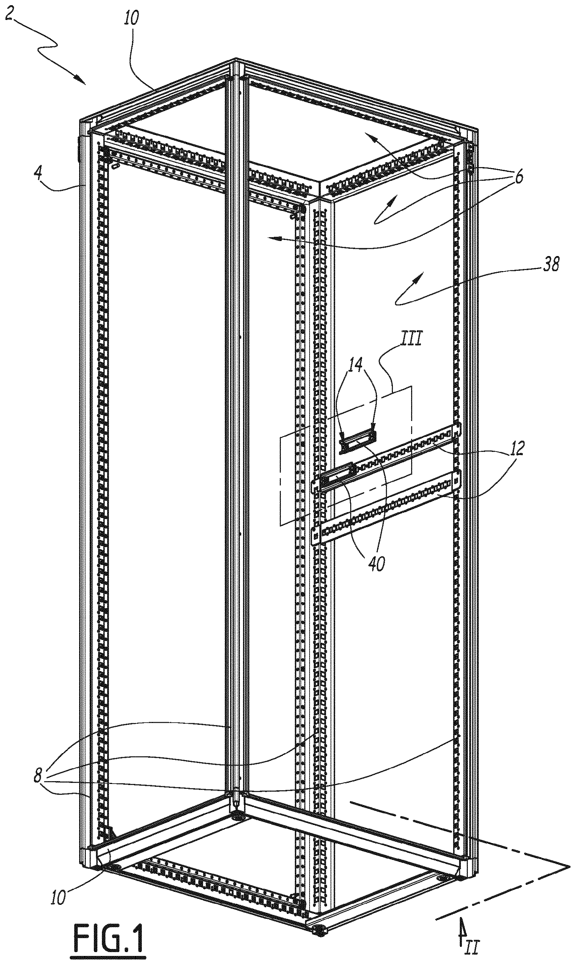

Une armoire électrique 2 est représentée en figure 1. Selon des modes de réalisation donnés à titre d'exemple, l'armoire électrique 2 est une armoire destinée à contenir des appareils électriques pour la répartition de courant ou le contrôle d'une machine. Ces appareils électriques peuvent comprendre des répartiteurs de courant, des disjoncteurs, des automates ainsi que d'autres matériels.

L'armoire électrique 2 est représentée posée sur une surface horizontale et comprend une armature 4 et des panneaux 6 qui sont rapportés à l'armature 4.

L'armature 4 est formée d'une structure métallique qui comprend quatre montants 8 verticaux, qui relient deux cadres 10 rectangulaires et horizontaux, l'un des cadres 10 étant posé sur le sol.

Les panneaux 6 peuvent être des panneaux latéraux fixes, tels que le panneau 6 représenté sur la figure 1 sur la droite de l'armature 4, auquel cas les panneaux 6 sont fixés à l'armature 4 par des organes de fixation tels que des vis, les types de panneaux 6 et les méthodes de fixation n'étant pas limitatifs. Les panneaux 6 peuvent aussi être des capots obturant les cadres 10 de l'armature pour définir son toit, tel que représenté sur le haut de la figure 1, ou encore des panneaux latéraux mobiles tels qu'une porte, représentée sur la gauche de la figure 1, auquel cas les panneaux 6 sont montés sur des charnières et éventuellement munis d'une glissière de retenue et/ou d'une serrure.

L'armature 4 comprend, en outre, deux traverses 12, qui relient horizontalement deux montants consécutifs. Bien entendu le nombre et la disposition des traverses 12 représentés sur la figure 1 ne sont pas limitatifs, et d'autres traverses 12 peuvent être montées sur l'armature 4 en fonction du type et du nombre d'équipements électriques qui doivent être installés dans l'armoire 2.

Dans ce qui suit, on décrit plus particulièrement la façon dont le panneau 6 à droite de l'armoire 2 est rapporté sur l'armature 4, ce panneau étant visible aux figures 1 à 3. Cette description s'applique, par transposition, aux autres panneaux 6.

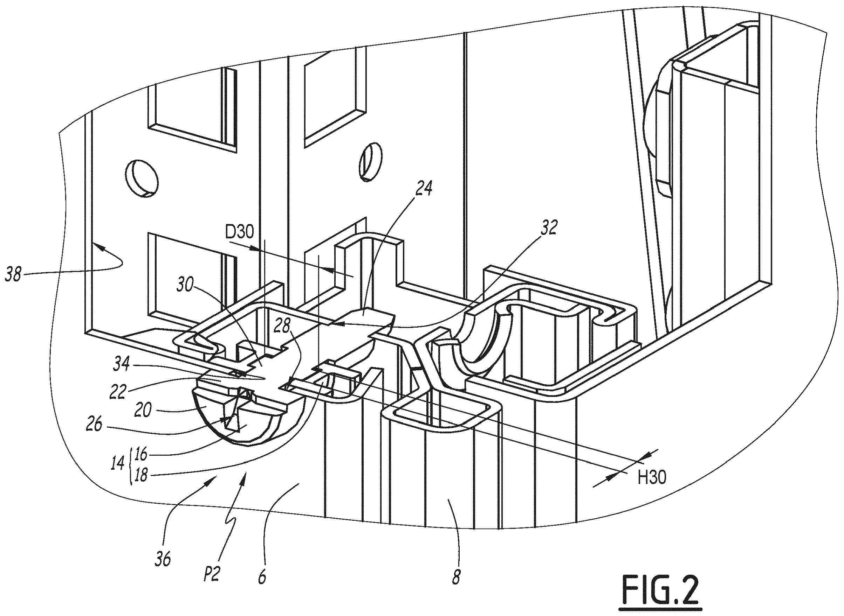

Comme bien visible en figure 2, le panneau 6 est rapporté à l'armature 4 à l'aide d'un sous-ensemble de fixation 14. Le sous-ensemble de fixation 14 comprend un premier organe de fixation 16 et une cale 18. Dans l'exemple de la figure 2, le premier organe de fixation 16 est une vis 20. Le sous-ensemble de fixation 14 est représenté sur la figure 2 dans une configuration P2 dite « configuration assemblée », dans laquelle le premier organe de fixation 16 coopère avec la cale 18, les principes de cette coopération étant détaillés plus loin.

La vis 20 comprend une tête 22 et une tige 24. La tête 22 est pourvue d'une empreinte 26 et définit un épaulement 28 orienté vers la tige 24. L'empreinte 26 permet d'exercer, sur la vis 20 et au moyen d'un outil adapté, un couple d'entraînement en rotation de cette vis 20 pour son vissage ou son dévissage sur une structure voisine. En exemple non limitatif, l'empreinte 26 est une empreinte cruciforme. En variantes non représentées, l'empreinte 26 de la vis 20 peut être une empreinte hexagonale à six pans creux, ou une empreinte à six lobes, dite aussi empreinte « Torx » (marque déposée).

La tige 24 présente un diamètre et est pourvue d'un filetage dit « auto-taraudeur », qui permet à la vis 20 de créer un taraudage lorsqu'elle est vissée dans un alésage d'une pièce métallique, ce qui assure un bon contact électrique entre la vis et la pièce métallique. En ce sens, la vis 20 est une vis dite « auto-taraudeuse ». En exemple non limitatif, la vis 20 est une vis auto-taraudeuse dite « trilobée ».

La vis 20 comprend, en outre, un collet 30 ménagé radialement en saillie à la périphérie de la tige 24. Le collet 30 est un cylindre de section circulaire co-axial avec la tige 24 et présente un diamètre D30, supérieur au diamètre de la tige 24, et une hauteur H30 mesurée parallèlement à l'axe de la tige 24.

Autrement dit, la vis 20 est un premier exemple d'organe de fixation 16, dans lequel le collet 30 est une protubérance radiale cylindrique ménagée sur cet organe de fixation 16.

Dans l'exemple de la figure 2, la vis 24 passe par un orifice 34 ménagé dans le panneau 6, est vissée dans un alésage 32 du montant 8, et l'épaulement 28 est en appui sur une face externe 36 du panneau 6.

Le sous-ensemble de fixation 14 est en configuration assemblée P2, ainsi lorsque la vis 24 est dévissée de l'alésage 32, la cale 18, qui coopère avec le collet 30, maintient la vis 24 dans l'orifice 34, ce qui empêche de perdre la vis 24 lors du démontage du panneau 6. Lors du remontage du panneau 6 sur l'armature 4, la vis 24 est déjà en position dans l'orifice 34, alignée avec l'alésage 32 du montant 8.

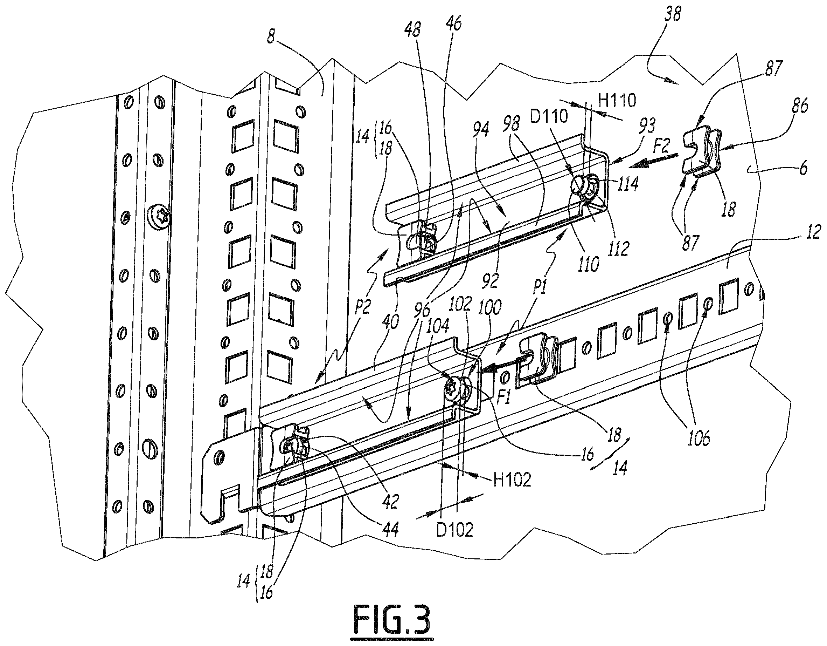

Sur la figure 3, le détail de l'armoire 2 représenté comprend aussi deux rails de montage 40, qui sont montés sur une face interne 38 du panneau 6. Dans l'exemple des figures, les rails de montage 40 présentent un profil normalisé en forme de Oméga pour le montage d'appareils électriques. Les rails de montage 40 sont aussi dits « rails DIN de 35 mm ».

Le rail de montage 40 représenté sur le bas de la figure 3 est monté sur une traverse 12 avec un sous-ensemble de fixation 14 comprenant une cale 18 et un deuxième organe de fixation 42, le deuxième organe de fixation 42 étant une vis 44, dont la tête est un deuxième exemple de protubérance radiale cylindrique.

Le rail de montage 40 représenté sur le haut de la figure 3 est, quant à lui, monté directement sur la face interne 38 du panneau 6 avec un sous-ensemble de fixation 16 comprenant une cale 18 et un troisième exemple d'organe de fixation 46, qui est un téton 48 de fixation, et dont la tête est un troisième exemple de protubérance radiale cylindrique.

On comprend bien que dans tous les exemples considérés, la cale 18, qui présente chaque fois la même structure, coopère avec un organe de fixation 16, qui est selon les cas une vis 20 avec un collet 30, une vis 42 sans collet ou un téton 48, et qui dans tous les cas présente une protubérance radiale cylindrique.

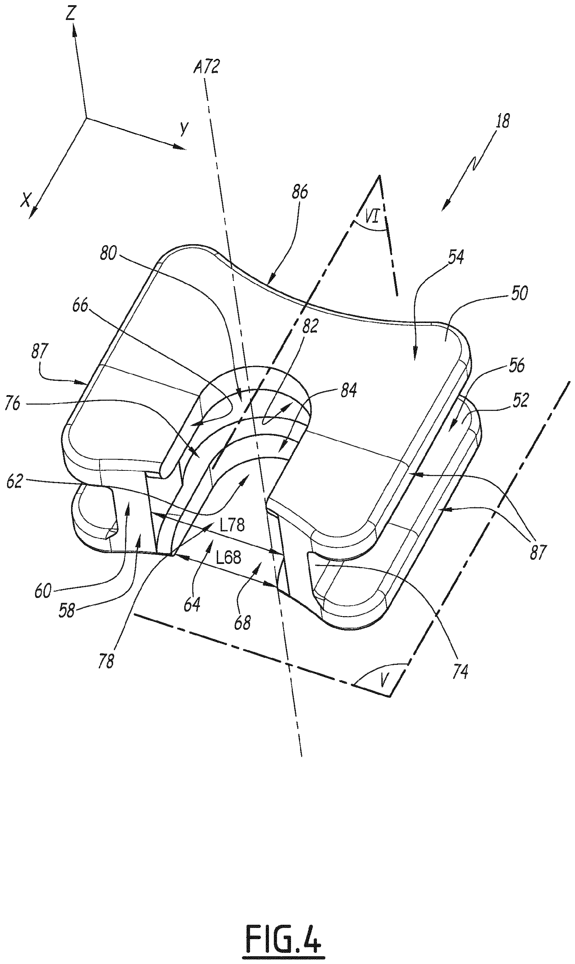

La structure de la cale 18 est à présent décrite en détail, à l'aide des figures 4 à 6.

La cale 18 est monolithique, c'est-à-dire réalisée d'une seule pièce, par exemple par un procédé d'injection, sans que cela ne préjuge d'un mode de production de la cale 18.

La cale 18 est réalisée en un matériau apte à se déformer élastiquement sous l'action d'un opérateur. La cale 18 est par exemple réalisée en matériau synthétique, ce matériau synthétique étant avantageusement compatible avec le procédé d'injection.

De façon préférentielle, ce matériau synthétique est « non chargé », c'est-à-dire qu'il contient peu ou pas de charges. Les charges sont des particules minérales ou organiques rajoutées à la matière synthétique pour, outre abaisser le cout global du matériau, ajuster les propriétés du matériau, par exemple en termes de dureté, de conductivité ou d'élasticité, cette liste de propriétés n'étant pas limitative. À titre d'exemples non limitatifs, les charges peuvent comprendre de la poudre de carbonate de calcium, de silice, du noir de carbone, ou des fibres telles que les fibres de verre, etc. En particulier, un matériau synthétique « peu chargé » ou « non chargé » est plus déformable qu'un matériau dit « chargé », qui présente un module d'Young plus élevé. Les effets des charges sur les propriétés du matériau n'étant pas linéaires, un premier matériau comprenant quelques pourcents de charges peut présenter une élasticité identique à un deuxième matériau ne comprenant pas de charge, mais le cout du premier matériau sera inférieur.

Quel que soit le type de charges utilisées, le taux massique de charge du matériau de la cale 18 est inférieur ou égal à 30% de charges. En particulier, le taux de fibre de verre du matériau de la cale 18 est inférieur ou égal à 30%, de préférence inférieur ou égal à 20%, de préférence encore inférieur ou égal à 10%, voire encore inférieur ou égal à 5%.

De préférence, la cale 18 est réalisée en polyamide non chargé.

La cale 18 comprend une paroi supérieure 50 et une paroi inférieure 52, parallèle à la paroi supérieure 50. La paroi supérieure 50 et la paroi inférieure 52 sont en forme de plaques, présentent une forme sensiblement rectangulaire identique l'une à l'autre et sont placées en regard l'une de l'autre. La paroi supérieure 50 et la paroi inférieure 52 présentent chacune une face externe 54 et une face interne 56, les faces internes 56 étant tournées l'une vers l'autre et se faisant face l'une à l'autre.

La paroi supérieure 50 et la paroi inférieure 52 présentent chacune un rebord avant 58, et les deux rebords avant 58 définissent une face avant 60.

Par commodité, on définit sur les figures 4 à 6 un repère orthonormé direct X, Y, Z, qui est lié à la cale 18 et orienté de telle sorte que la face avant 60 est orthogonale à l'axe X, et les faces externes 54 et internes 56 sont orthogonale à l'axe Z.

Comme bien visible sur la figure 4, une première encoche 62 est ménagée dans la première paroi 50, et une deuxième encoche 64 est ménagée dans la deuxième paroi 52. Les première et deuxième encoches 62 et 64 ont une forme similaire en U et sont alignées selon l'axe Z, c'est-à-dire que la première encoche 62 peut être obtenue essentiellement par translation de la deuxième encoche 64 parallèlement à l'axe Z.

Chacune des première et deuxième encoches 62 et 64 comporte un rebord interne 66 définissant une embouchure 68, ici à l'avant de la cale 18, et une base arrondie 70. La base arrondie 70 est par exemple une section de cylindre de section circulaire et de génératrice parallèle à l'axe Z. On définit un axe principal A72 comme étant la génératrice de la base arrondie 70 de chacune des première et deuxième encoches 62 et 64. Les première et deuxième encoches 62 et 64 sont donc alignées selon l'axe principal A72, qui est ici parallèle à l'axe Z. L'embouchure 68 présente une largeur L68 mesurée orthoradialement à l'axe principal A72.

La cale 18 comprend, en outre, une cloison recourbée 74. La cloison recourbée 74 présente une forme de U, et connecte la première paroi 50 à la deuxième paroi 52. La cloison recourbée 74 s'étend parallèlement à l'axe principal A72 entre les faces internes 56 des première et deuxième parois 50 et 52 et en retrait des rebords internes 66 des première et deuxième encoches 62 et 64, et la partie des faces internes 56 comprise entre la cloison recourbée 74 et les rebords internes 66 définit des guides axiaux 76.

La cloison recourbée 74 définit une ouverture frontale 78, qui présente une largeur L78 mesurée orthoradialement à l'axe principal A72.

L'ouverture frontale 78 a une largeur L78 supérieure à la largeur L68 de l'embouchure 68 des première et deuxième encoches 62 et 64.

Un chambrage 80 est ménagé dans la cloison recourbée 74, le chambrage 80 étant de forme cylindrique de diamètre D80, centré sur l'axe principal A72 et définissant un fond 82. Le fond 82 et l'ouverture frontale 78 délimitent un logement central 84 radialement par rapport à l'axe central A72, tandis que les guides axiaux 76 opposés des parois 50 et 52 délimitent le logement central 84 axialement par rapport à l'axe central A72. Le diamètre D80 du chambrage 80 est aussi un diamètre du logement central 84, et le diamètre D80 est supérieur à la largeur L78 de l'ouverture frontale 78 de la cloison recourbée 74. Autrement dit, le chambrage 80 est ménagé dans l'épaisseur de la cloison recourbée 74 et élargit le logement central 84 par rapport à l'ouverture frontale 78.

Le logement central 84 présente donc une forme cylindrique et est aligné sur l'axe principal A72. Le logement central 84 est donc coaxial avec l'axe principal A72 et est aussi aligné sur les première et deuxième encoches 62 et 64.

À l'opposé de la face avant 60, la cale 18 présente une face arrière 86. La face arrière 86 est incurvée, pour faciliter la manipulation de la cale 18 par un opérateur, notamment pour faciliter l'application d'un effort pour engager la cale 18 sur un organe de fixation 16 en configuration engagée. La cale 18 présente aussi des patins de centrage 87, qui sont ici formés par les bords latéraux des parois 50 et 52 et présentent des faces parallèles entre elles et orthoradiales à l'axe principal A72. Les patins ce centrage 87 sont ainsi parallèles aux rebords internes 66.

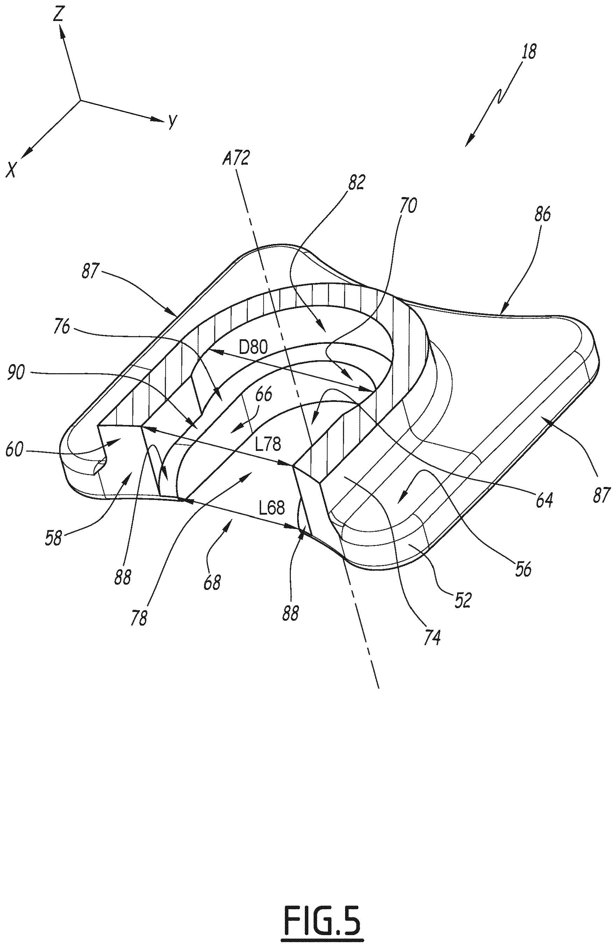

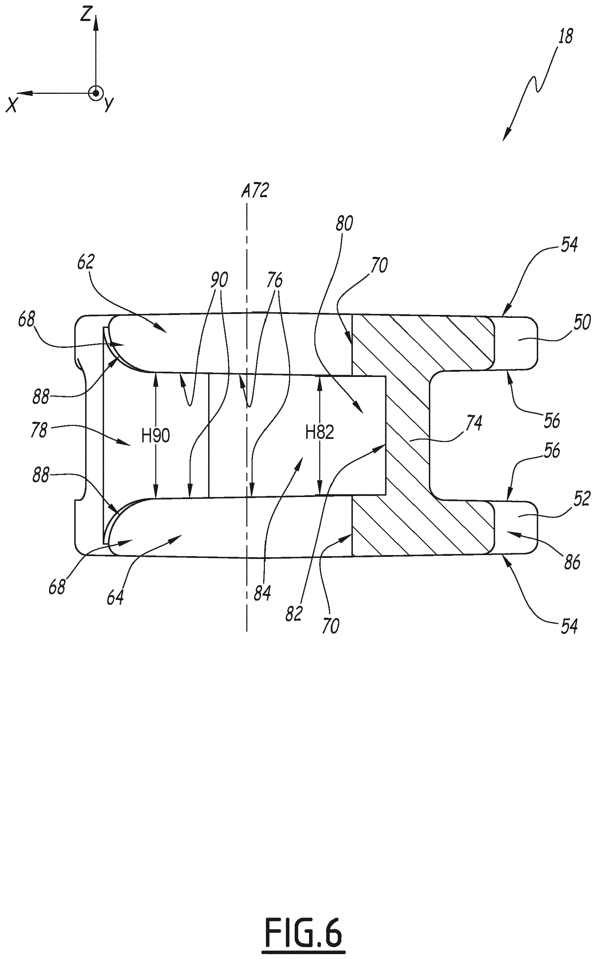

Comme bien visible sur les figures 5 et 6, on définit une hauteur H82 du fond 82 comme étant la distance entre les guides axiaux 76 mesurée parallèlement à l'axe principal A72 au plus proche de la face arrière 86.

Chaque guide axial 76 comprend, en outre, une portion arrondie 88 et une portion plane 90. Les portions planes 90 des guides axiaux 76 sont raccordées à la face avant 60 par les portions arrondies 88. On définit une hauteur H90 comme étant la distance, mesurée parallèlement à l'axe principal, entre les portions planes 90 situées en regard l'un de l'autre suivant l'axe principal A72, au point le plus proche de la face avant 60.

Le logement central 84 est adapté pour accueillir, aux jeux d'assemblage près, la protubérance radiale cylindrique d'un organe de fixation 16.

La hauteur H82 est ainsi supérieure ou égale la hauteur H30 du collet 30 de l'exemple de la figure 2, ou de façon plus générale, à la hauteur de la protubérance radiale cylindrique.

Un jeu axial peut être laissé volontairement entre la protubérance radiale cylindrique et les guides axiaux 76 en configuration assemblée, notamment dans l'exemple de la figure 2 pour que le sous-ensemble de fixation ne gêne pas la rotation de la vis 20 traversant le panneau 6 par l'orifice 34.

En variante non représentée, la hauteur H82 peut bien entendu être choisie égale, voire légèrement inférieure, à la hauteur de la protubérance radiale cylindrique, pour que la protubérance radiale cylindrique soit maintenue sans jeu axial dans le logement central 84.

Avantageusement, la hauteur H90 est supérieure ou égale à la hauteur H82, notamment pour faciliter le démoulage de la cale 18 lorsque celle-ci est fabriquée par injection de matière synthétique dans des moules. Dans ce cas, les portions planes 90 ne sont pas orthogonales à l'axe principal A72, mais forment un angle dit « de dépouille ». Ainsi les guides axiaux 76, qui délimitent axialement suivant l'axe principal A72 le logement central 84, sont évasés axialement en direction de l'ouverture frontale 78.

Les portions arrondies 88 qui sont situées en regard l'une de l'autre par rapport à l'axe principal A72 s'éloignent l'une de l'autre à mesure que l'on se rapproche de la face avant 60. Autrement dit, les portions arrondies 88 qui raccordent les guides axiaux 76 à la face avant 60 sont évasés axialement en direction de la face avant 60.

Dans l'exemple de la figure 2, le diamètre D80 du logement central 84 est supérieur ou égal au diamètre D30 du collet 30. Plus généralement, le diamètre D80 du logement central 84 est supérieur ou égal au diamètre de la protubérance radiale cylindrique. Ainsi, aux jeux d'assemblage près, la rotation de cale 18 par rapport à l'organe de fixation 16 autour de l'axe principal A72 n'est pas gênée par la coopération de la protubérance radiale cylindrique avec le logement central 84 en configuration assemblée.

On décrit à présent l'exemple de la figure 3.

Les deux rails de montage 40 représentés en figure 3 sont des profilés métalliques qui présentent une structure identique l'une à l'autre. Chaque rail de montage 40 comprend un fond 92, avec un côté externe 93 et un côté interne 94, deux parois latérales 96 et deux rebords externes 98. Des trous 100 sont ménagés dans le fond 92 de chacun des rails de montage 40.

Les vis 44 présentent chacune une tête 102 sensiblement cylindrique, avec un diamètre D102 et une hauteur H102. La tête 102 de chaque vis 44 présente une face externe 104, dans laquelle est ménagée une empreinte, et un épaulement orienté vers la tige, l'épaulement n'étant pas référencé. Dans l'exemple non limitatif de la figure 3, cette empreinte est une empreinte à six lobes telle que définie précédemment. Les vis 44 comprennent, en outre, une tige filetée non référencée sur les figures, qui est avantageusement auto-taraudeuse.

Des alésages 106 sont ménagés dans la traverse 12. Les vis 44 sont partiellement vissées dans les alésages 106.

La cale 18 représentée à droite du rail 40 inférieur de la figure 3 n'est pas en contact avec la vis 44 avoisinante et est donc dans une configuration dite configuration désassemblée P1. Par un mouvement de translation suivant la flèche F1, l'ouverture frontale 78 de la cale 18 vient en contact avec la tête 102 de la vis 44 avoisinante, tandis que les patins de centrage 87 coopèrent avec les parois latérales 96 du rail de montage 40 pour centrer transversalement le rail 40 par rapport à la vis 44.

Sous l'effet de la pression exercée par l'opérateur sur la face arrière 86 suivant une direction radiale centripète à l'axe principal A72, la cloison recourbée 74 se déforme élastiquement et l'ouverture frontale 78 s'élargit suivant une direction orthoradiale à l'axe principal A72 et laisse passer la tête 102 de la vis 44, tandis que les portions arrondies 88 de la cale 18, puis les portions planes 90 des guides axiaux 76, contribuent à centrer la tête de la vis 44 axialement par rapport à l'axe principal 72. La tige de la vis 44 traverse alors l'embouchure 68 de l'une des première ou deuxième encoches 62 ou 64 de la cale 18.

Le mouvement de translation de la cale 18 suivant la flèche F1 se poursuit jusqu'à ce que la tête 102 de la vis 44 se retrouve logée dans le logement central 84, et la tige de la vis 44 est alors logée dans la base arrondie 70 de l'une des première ou deuxième encoches 62 ou 64 de la cale 18. Autrement dit, la tige de la vis 44 est logée dans le fond d'au moins une des encoches en U 62 ou 64 de la première ou de la deuxième paroi 50 ou 52, tandis que la protubérance radiale cylindrique est reçue dans le logement central 84.

Cette configuration correspond à la configuration assemblée P2 du sous-ensemble de fixation 14 situé en bas à gauche de la figure 3. L'axe de la tête 102, autrement dit l'axe de la protubérance radiale cylindrique, est alors coaxial avec l'axe principal A72.

Dans la configuration assemblée P2, La cloison recourbée 74 reprend élastiquement la même forme initiale que dans la configuration désassemblée P1, et empêche la tête 102 de la vis 44 de ressortir du logement central 84 par une translation de direction opposée à la flèche F1 sans action de la part d'un opérateur. Les mouvements de translation de la vis 44 par rapport à la cale 18 suivant l'axe principal A72 sont bloqués par l'action de butée des portions planes 90 des guides axiaux 76 sur la face externe 94 et sur l'épaulement de la tête 102 de la vis 44.

Les vis 44 peuvent ensuite être vissés entièrement, c'est-à-dire jusqu'à ce que la cale 18 soit serrée entre la tête 102 de la vis 44 et le rail de montage 40.

Pour démonter le rail 40, il suffit à l'opérateur de desserrer les vis 44 qui l'immobilisent, puis de retirer les cales 18 par une action manuelle : le rail 40 peut alors être déplacé en l'éloignant de la traverse 12, sans avoir à complètement démonter les vis 44, qui ne peuvent être perdues.

Dans l'exemple du haut de la figure 3, le rail 40 est rapporté au panneau 6 par des tétons 48.

Chaque téton 48 présente une tête 110, une tige 112 et une embase 114, la tige 112 reliant l'embase 114 à la tête 110.

La tige 112 définit un axe et un diamètre, et la tête 110 présente une forme cylindrique de section circulaire et de génératrice coaxiale à l'axe de la tige 112. La tête 110 présente un diamètre D110 supérieur au diamètre de la tige 112 et une hauteur H110.

L'embase 114 est ici directement soudée à la face interne 38 panneau 6. Les trous 100 du rail 40 présentent un diamètre supérieur au diamètre D110 de la tête 110 du téton 48, ainsi le côté externe 93 du rail 40 est au contact de la face interne 38 du panneau 6, tandis que les tiges 112 des tétons 48 passent par les trous 100.

La cale 18 située à droite du rail 40 du haut de la figure 3 est en position désassemblée P1. De façon analogue à l'exemple du bas de la figure 3, sous l'action d'un opérateur, la cale 18 est déplacée en translation suivant une direction indiquée par la flèche F2, et l'ouverture frontale 78 se retrouve au contact de la tête 110 du téton 48. Les portions arrondies 88 assurent le positionnement axial suivant l'axe principal A72 de la cale 18 par rapport à la tête 110 du téton 48, tandis que les patins de centrage 87 coopèrent avec les parois latérales 96 du rail de montage 40.

Par déformation élastique de l'ouverture frontale 78 suivant une direction orthonormale à l'axe principal A72, la tête 110 progresse dans la cloison recourbée 74 jusqu'à atteindre le logement central 84. La cale 18 est alors en configuration assemblée P2 sur la tête 110 du téton 48.

La cale 18 reprend alors élastiquement sa forme initiale, et la tête 110 du téton 48 est retenue dans le logement central 84. Le côté externe 93 du fond 92 du rail 40 est alors en appui sur la face interne 38 du panneau 6, tandis que la cale 18, plus exactement l'une des faces externes 54 de la première ou de la deuxième paroi 50 ou 52, est en appui sur le côté interne 94 du fond 92 du rail 40, et que les patins de centrage 87 assurent le positionnement du rail 40 par rapport aux tétons 48.

Ainsi grâce aux cales 18, le rail 40 peut être monté ou démonté sans outil par un opérateur, alors que les tétons 48 sont soudés au panneau 6, c'est-à-dire indémontables.

On comprend bien que le collet 30 de la vis 20 de la figure 2, ainsi que la tête 102 de la vis 44 et la tête 110 du téton 48 de la figure 3 sont autant d'exemples d'une protubérance radiale cylindrique, qui coopère avec le logement central 84 de la cale 18 en position assemblée P2. En variante, il est possible d'utiliser des organes de fixation 16 n'étant pas nécessairement identiques à ceux décrits dans les exemples ci-dessus, du moment que ces organes de fixation sont aptes à coopérer avec la cale 18 et qu'ils comprennent à cet effet une protubérance radiale cylindrique conforme aux principes décrits ci-dessus.

De nombreux modes de réalisation sont possibles.

Dans l'exemple des figures, le rebord interne 66 présente, au voisinage de l'embouchure 78, des surfaces planes et une largeur L78 constante. En variante non représentée, les surfaces du rebord interne ne sont pas planes mais peuvent comporter des reliefs qui contribuent à l'effet de retenue de l'organe de fixation 16 en configuration assemblée.

Selon une autre variante, les rebords internes 66 sont divergents, c'est-à-dire que la distance entre les rebords internes 66 de la première paroi 50 et/ou de la deuxième paroi 52 augmente à mesure que l'on se rapproche du rebord avant 58.

Dans les exemples illustrés, des trous 100 circulaires sont ménagés dans le fond du rail de montage 40 pour laisser passer la tige 24 d'un organe de fixation 16. En variante non représentée, les trous peuvent être oblongs et orientés dans le sens de la longueur du rail de montage, ce qui permet de déplacer le rail de montage 40 par glissement sur l'une des première ou deuxième parois 50 ou 52 en appui sur le fond du rail de montage 40. En particulier, un trou oblong, de diamètre inférieur au diamètre de la protubérance radiale cylindrique, débouchant sur un orifice circulaire de diamètre supérieur au diamètre de la protubérance radiale cylindrique pour réaliser un « trou de serrure », permet de réaliser des glissières démontables.

Dans l'exemple des figures, les première et deuxième parois 50 et 52 sont de la même épaisseur. En variante non représentée, les première et deuxième parois 50 et 52 peuvent avoir des épaisseurs différentes, pour accommoder divers types d'organes de fixation, en particulier si un rail de montage 40 muni de trous oblongs est appelé à être déplacé en translation par rapport au sous-ensemble de fixation 14.

Dans l'exemple des figures, les patins de centrage 87 des cales 18 sont dimensionnés pour assurer le centrage transversal du rail de montage 40, qui est ici un rail au profil normalisé DIN de 35 mm. Bien entendu les patins de centrage 87 peuvent présenter d'autres dimensions, pour coopérer avec des rails de montage 40 présentant d'autres géométries, normalisées ou non.

Le mode de réalisation et les variantes mentionnés ci-dessus peuvent être combinés pour générer de nouveaux modes de réalisation de l'invention.

## Revendications

1. Cale (18) de fixation destinée à recevoir un organe de fixation (16) avec une protubérance radiale cylindrique (30, 102, 110), la cale (18) étant réalisée en un matériau apte à se déformer élastiquement sous l'action d'un opérateur, la cale de fixation comprenant
- une première paroi (50) dans laquelle est ménagée une première encoche (62), la première encoche ayant une forme de U,
- une deuxième paroi (52) dans laquelle est ménagée une deuxième encoche (64), la deuxième encoche ayant une forme de U, la première paroi et la deuxième paroi étant superposées et orthogonales à un axe principal (A72) de la cale, les première et deuxième encoches (62, 64) étant de formes similaires et alignées selon l'axe principal, chaque encoche comportant un bord interne (66) définissant une embouchure (68) et une base arrondie (70) de forme circulaire centrée sur l'axe principal,
- une cloison recourbée (74) en forme de U, la cloison recourbée connectant la première paroi à la deuxième paroi en s'étendant parallèlement à l'axe principal et en retrait du bord interne des encoches, la cloison recourbée définissant un logement central (84) aligné sur les première et deuxième encoches (62, 64), et dans laquelle ledit logement central (84) comporte une ouverture frontale (78) et un fond (82), l'ouverture frontale ayant une largeur (L78) supérieure à la largeur (L68) de l'embouchure (68) des encoches (62, 64) en U, **caractérisée en ce que** ladite cloison recourbée (74) comporte un chambrage (80) ménagé dans l'épaisseur de la cloison recourbée (74) qui élargit le logement central (84) par rapport à l'ouverture frontale (78), le chambrage présentant une forme cylindrique coaxiale avec l'axe principal (A72) et de diamètre (D80) supérieur à la largeur (L78) de l'ouverture frontale (78), le logement central (84) étant adapté pour accueillir, aux jeux d'assemblage près, la protubérance radiale cylindrique (30, 102, 110) de l'organe de fixation (16).

2. Cale (18) de fixation selon la revendication précédente, **caractérisée en ce que** le logement central (84) est délimité axialement suivant l'axe principal (A72) par des guides axiaux (76), qui sont évasés axialement en direction de l'ouverture frontale (78).

3. Cale de fixation (18) selon la revendication précédente, **caractérisée en ce que** les guides axiaux (76) sont raccordés à une face avant (60) par des portions arrondies (88) évasées axialement en direction de l'ouverture frontale (78).

4. Cale de fixation (18) selon l'une quelconque des revendications précédentes, **caractérisée en ce que** les première et deuxième parois (50, 52) présentent des patins de centrage (87) parallèles aux bords internes (66) et configurés pour coopérer sans jeu avec un rail de montage (40).

5. Cale de fixation (18) selon l'une quelconque des revendications précédentes, **caractérisée en ce que** l'ouverture frontale (78) est apte à se déformer élastiquement selon une direction orthoradiale à l'axe principal (A72).

6. Cale de fixation (18) selon l'une quelconque des revendications précédentes, **caractérisée en ce que** la cale de fixation est réalisée d'une seule pièce en un matériau synthétique, de préférence en polyamide non chargé.

7. Armoire électrique (2) comportant une armature (4), **caractérisée en ce que** l'armoire comprend au moins une cale de fixation (18) selon l'une quelconque des revendications précédentes et un organe de fixation (16), l'organe de fixation comprenant une tige (24, 112) et une protubérance radiale cylindrique (30, 102, 110) liée coaxialement à la tige, dans laquelle la tige coopère avec la base arrondie (70) d'au moins une des encoches en U (62, 64) de la première ou de la deuxième paroi (50, 52), tandis que la protubérance radiale cylindrique coopère avec le logement central (84).

8. Armoire électrique (2) selon la revendication 7, **caractérisée en ce que** l'armoire électrique comprend au moins un panneau (6) avec une face externe (36), une face interne (38) et un orifice (34) reliant la face interne à la face externe, dans laquelle l'organe de fixation (16) est une vis (20), la vis comportant une tête (22) et une tige (24) filetée, la tête présentant un épaulement (28) du côté de la tige, la protubérance radiale cylindrique étant un collet (30) ménagé coaxialement sur la tige entre la tête et le bout de la tige, l'orifice (34) du panneau présentant un diamètre supérieure au diamètre (D30) du collet (30) et inférieur au diamètre de la tête (22) de la vis, le panneau (6) étant rapporté sur cette armature (4) au moyen de la vis, la tête (22) de la vis étant située du côté de la face externe (36) du panneau, la cale (18) étant en configuration assemblée (P2) sur le collet (30) du côté de la face interne (38) du panneau, et la tige (24) de la vis traversant l'orifice (34) du panneau et étant vissée dans l'armature (4).

9. Armoire électrique (2) selon la revendication 7, **caractérisée** en ce l'armature (4) comprend au moins une traverse (12) avec un alésage (106), un rail de montage (40) avec un fond (92) et deux parois latérales (96), le rail de montage définissant un côté externe (93) et un côté interne (94), un deuxième orifice (100) étant ménagé dans le fond (92), dans laquelle l'organe de fixation (16) est une vis (44) comportant une tête (102) avec un diamètre (D102) et une tige filetée, la protubérance radiale cylindrique de l'organe de fixation (16) étant la tête de la vis, le deuxième orifice (100) étant de diamètre supérieur au diamètre (D102) de la tête de la vis, le rail de montage (40) étant rapporté sur la traverse (12) au moyen de la vis (44), dont la tige traverse le deuxième orifice du rail de montage et est vissée dans l'alésage (106) de la traverse (12), la cale (18) étant en configuration assemblée (P2) sur la tête (102) de la vis, l'une des première ou deuxième parois (50, 52) de la cale étant en appui sur le côté interne (94) du fond (92) du rail de montage tandis que le coté externe (93) du fond (92) du rail est en appui sur la traverse, les patins de centrage (87) coopérant avec les deux parois latérales (96) du rail de montage (40).

10. Armoire électrique (2) selon la revendication 7, **caractérisée en ce que** l'armoire électrique comprend au moins un panneau (6), rapporté sur cette armature (4) et présentant une face interne (38), un rail de montage (40) avec un fond (92) et deux parois latérales (96), définissant un côté externe (93) et un côté interne (94), un deuxième orifice (100) étant ménagé dans le fond (92) du rail de montage, dans laquelle l'organe de fixation (16) est un téton (48) comprenant une tige (112), une embase (114) et une tête (110), la protubérance radiale cylindrique de l'organe de fixation (16) étant la tête (110) du téton, l'embase du téton étant soudée à la face interne (38) du panneau,
le deuxième orifice (100) étant de diamètre supérieur au diamètre (D110) de la tête (110) du téton, la tige (112) du téton traversant le deuxième orifice du rail de montage, la cale (18) étant en configuration assemblée (P2) sur la tête du téton, l'une des première ou deuxième parois (52, 54) de la cale étant en appui sur le côté interne (94) du fond (92) du rail de montage tandis que le coté externe (93) du fond du rail est en appui sur la face interne (36) du panneau (6), les patins de centrage (87) coopérant avec les deux parois latérales (96) du rail de montage.

## Patentansprüche

1. Befestigungskeil (18), der ausgelegt ist, um ein Befestigungsorgan (16) mit einem zylindrischen radialen Vorsprung (30, 102, 110) aufzunehmen, wobei der Keil (18) aus einem Material hergestellt ist, das geeignet ist, um sich unter der Einwirkung eines Bedieners elastisch zu verformen, wobei der Befestigungskeil Folgendes umfasst:
- eine erste Wand (50), in der eine erste Kerbe (62) angebracht ist, wobei die erste Kerbe die Form eines U aufweist,
- eine zweite Wand (52), in der eine zweite Kerbe (64) angebracht ist, wobei die zweite Kerbe die Form eines U aufweist, wobei die erste Wand und die zweite Wand überlagert und orthogonal zu einer Hauptachse (A72) des Keils sind, wobei die erste und zweite Kerbe (62, 64) ähnlich gebildet und gemäß der Hauptachse ausgefluchtet sind, wobei jede Kerbe einen inneren Rand (66) umfasst, der eine Mündung (68) und eine abgerundete Basis (70) mit runder Form, zentriert auf der Hauptachse, definiert,
- eine gekrümmte Zwischenwand (74) in Form eines U, wobei die gekrümmte Zwischenwand die erste Wand und die zweite Wand verbindet, indem sie sich parallel zur Hauptachse und zurückgesetzt vom inneren Rand der Kerben erstreckt, wobei die gekrümmte Zwischenwand eine zentrale Aufnahme (84) definiert, die auf die erste und zweite Kerbe (62, 64) ausgefluchtet ist, und wobei die zentrale Aufnahme (84) eine frontale Öffnung (78) und einen Boden (82) umfasst, wobei die frontale Öffnung eine Breite (L78) aufweist, die grösser als die Breite (L68) der Mündung (68) der U-förmigen Kerben (62, 64) ist, **dadurch gekennzeichnet, dass** die gekrümmte Zwischenwand (74) eine Senkung (80) umfasst, die in der Dicke der gekrümmten Zwischenwand (74) angebracht ist, die die zentrale Aufnahme (84) mit Bezug auf die frontale Öffnung (78) verlängert, wobei die Senkung eine koaxiale zylindrische Form mit der Hauptachse (A72) und einen Durchmesser (D80) aufweist, der grösser als die Breite (L78) der frontalen Öffnung (78) ist, wobei die zentrale Aufnahme (84) angepasst ist, um, bis aus die Montagespiele, den zylindrischen radialen Vorsprung (30, 102, 110) des Befestigungsorgans (16) aufzunehmen.

2. Befestigungskeil (18) nach dem vorhergehenden Anspruch, **dadurch gekennzeichnet, dass** die zentrale Aufnahme (84) axial gemäß der Hauptachse (A72) durch axiale Führungen (76) begrenzt ist, die axial in Richtung der frontalen Öffnung (78) erweitert sind.

3. Befestigungskeil (18) nach dem vorhergehenden Anspruch, **dadurch gekennzeichnet, dass** die axialen Führungen (76) mit einer vorderen Fläche (60) durch abgerundete Abschnitte (88) verbunden sind, die axial in Richtung der frontalen Öffnung (78) erweitert sind.

4. Befestigungskeil (18) nach einem der vorhergehenden Ansprüche, **dadurch gekennzeichnet, dass** die erste und zweite Wand (50, 52) Zentrierkufen (87) aufweisen, die parallel zu den inneren Rändern (66) und konfiguriert sind, um ohne Spiel mit einer Montageschiene (40) zusammenzuarbeiten.

5. Befestigungskeil (18) nach einem der vorhergehenden Ansprüche, **dadurch gekennzeichnet, dass** die frontale Öffnung (78) geeignet ist, um sich in einer orthoradialen Richtung zur Hauptachse (A72) elastisch zu verformen.

6. Befestigungskeil (18) nach einem der vorhergehenden Ansprüche, **dadurch gekennzeichnet, dass** der Befestigungskeil aus einem einzigen Stück aus synthetischem Material hergestellt ist, vorzugsweise aus unverstärktem Polyamid.

7. Schaltschrank (2), umfassend ein Gestell (4), **dadurch gekennzeichnet, dass** der Schrank mindestens einen Befestigungskeil (18) nach einem der vorhergehenden Ansprüche und ein Befestigungsorgan (16) umfasst, wobei das Befestigungsorgan einen Stift (24, 112) und einen zylindrischen radialen Vorsprung (30, 102, 110) umfasst, der koaxial mit dem Stift verbunden ist, wobei der Stift mit der abgerundeten Basis (70) mindestens einer der U-förmigen Kerben (62, 64) der ersten oder der zweiten Wand (50, 52) zusammenarbeitet, während der zylindrische radiale Vorsprung mit der zentralen Aufnahme (84) zusammenarbeitet.

8. Schaltschrank (2) nach Anspruch 7, **dadurch gekennzeichnet, dass** der Schaltschrank mindestens eine Platte (6) mit einer äußeren Fläche (36) einer inneren Fläche (38) und einem Loch (34) umfasst, das die innere Fläche mit der äußeren Fläche verbindet, wobei das Befestigungsorgan (16) eine Schraube (20) ist, wobei die Schraube einen Kopf (22) und einen gewindegeschnittenen Stift (24) umfasst, wobei der Kopf einen Absatz (28) auf der Seite des Stifts darstellt, wobei der zylindrische radiale Vorsprung ein Bund (30) ist, der koaxial auf dem Stift zwischen dem Kopf und dem Ende des Stifts angebracht ist, wobei das Loch (34) der Platte einen Durchmesser darstellt, der grösser als der Durchmesser (D30) des Bunds (30) und kleiner als der Durchmesser des Kopfs (22) der Schraube ist, wobei die Platte (6) auf dieses Gestell (4) mit Hilfe der Schraube aufgesetzt ist, wobei sich der Kopf (22) der Schraube an der Seite der äußeren Fläche (36) der Platte befindet, wobei sich der Keil (18) in der zusammengebauten Konfiguration (P2) auf dem Bund (30) der Seite der inneren Fläche (38) der Platte befindet und der Stift (24) der Schraube das Loch (34) der Platte durchquert und in das Gestell (4) geschraubt ist.

9. Schaltschrank (2) nach Anspruch 7, **dadurch gekennzeichnet, dass** der Schrank (4) mindestens einen Querbalken (12) mit einer Bohrung (106), eine Montageschiene (40) mit einem Boden (92) und zwei seitliche Wände (96) umfasst, wobei die Montageschiene eine äußere Seite (93) und eine innere Seite (94) definiert, wobei ein zweites Loch (100) in den Boden (92) angebracht ist, wobei das Befestigungsorgan (16) eine Schraube (44) ist, umfassend einen Kopf (102) mit einem Durchmesser (D102) und einem gewindegeschnittenen Stift, wobei der zylindrische radiale Vorsprung des Befestigungsorgans (16) der Schraubenkopf ist, wobei das zweite Loch (100) einen Durchmesser aufweist, der grösser als der Durchmesser (D102) des Kopfs der Schraube ist, wobei die Montageschiene (40) auf den Querbalken (12) mit Hilfe der Schraube (44) aufgesetzt ist, von der der Stift das zweite Loch der Montageschiene durchquert und in die Bohrung (106) des Querbalkens (12) geschraubt ist, wobei sich der Keil (18) in der zusammengebauten Konfiguration (P2) auf dem Kopf (102) der Schraube befindet, wobei eine der ersten und zweiten Wand (50, 52) des Keils auf der inneren Seite (94) des Bodens (92) der Montageschiene aufliegt, während die äußere Seite (93) des Bodens (92) der Schiene auf dem Querbalken aufliegt, wobei die Zentrierkufen (87) mit den zwei seitlichen Wänden (96) der Montageschiene (40) zusammenarbeiten.

10. Schaltschrank (2) nach Anspruch 7, **dadurch gekennzeichnet, dass** der Schaltschrank mindestens eine Platte (6) umfasst, die auf dieses Gestell (4) aufgesetzt ist, und eine innere Fläche (38), eine Montageschiene (40) mit einem Boden (92) und zwei seitliche Wände (96) darstellt, die eine äußere Seite (93) und eine innere Seite (94) definieren, wobei ein zweites Loch (100) in den Boden (92) der Montageschiene angebracht ist,
wobei das Befestigungsorgan (16) ein Zapfen (48) ist, umfassend einen Stift (112), einen Sockel (114) und einen Kopf (110), wobei der zylindrische radiale Vorsprung des Befestigungsorgans (16) der Kopf (110) des Zapfens (48) ist, wobei die Basis des Zapfens an die innere Seite (38) der Platte geschweißt ist,
wobei das zweite Loch (100) einen Durchmesser aufweist, der grösser als der Durchmesser (D110) des Kopfs (110) des Zapfens ist, wobei der Stift (112) des Zapfens das zweite Loch der Montageschiene durchquert, wobei sich der Keil (18) in der zusammengebauten Konfiguration (P2) auf dem Kopf des Zapfens befindet, wobei eine der ersten oder zweiten Wand (52, 54) des Keils auf der inneren Seite (94) des Bodens (92) der Montageschiene aufliegt, während die äußere Seite (93) des Bodens der Schiene auf der inneren Seite (36) der Platte (6) aufliegt, wobei die Zentrierkufen (87) mit den zwei seitlichen Wänden (96) der Montageschiene (40) zusammenarbeiten.

## Claims

1. A fixing wedge (18) intended to receive a fixing member (16) with a cylindrical radial protuberance (30, 102, 110), the wedge (18) being made from a material capable of deforming elastically under the action of an operator, the fixing wedge comprising:
- a first wall (50) in which a first notch (62) is arranged, the first notch being U-shaped,
- a second wall (52) in which a second notch (64) is arranged, the second notch being U-shaped, the first wall and the second wall being superimposed and orthogonal to a main axis (A72) of the wedge, the first and second notches (62, 64) having similar shapes and being aligned along the main axis, each notch including an inner edge (66) defining a mouth (68) and a rounded base (70) of circular shape centered on the main axis,
- a U-shaped curved partition (74), the curved partition connecting the first wall to the second wall while extending parallel to the main axis and withdrawn from the inner edge of the notches, the curved partition defining a central housing (84) aligned on the first and second notches (62, 64),
and wherein said central housing (84) includes a front opening (78) and a bottom (82), the front opening having a width (L78) greater than the width (L68) of the mouth (68) of the U-shaped notches (62, 64), **characterized in that** said curved partition includes a recess (80) arranged in the thickness of the curved partition (74) that widens the central housing (84) relative to the front opening (78), the recess having a cylindrical shape coaxial with the main axis (A72) and of diameter (D80) greater than the width (L78) of the front opening (78), the central housing (84) being suitable for accommodating, to within any assembly play, the cylindrical radial protuberance (30, 102, 110) of the fastening member (16).

2. The fixing wedge (18) according to the preceding claim, **characterized in that** the central housing (84) is axially delimited along the main axis (A72) by axial guides (76), which are axially flared toward the front opening (78).

3. The fixing wedge (18) according to the preceding claim, **characterized in that** the axial guides (76) are connected to a front face (60) by rounded portions (88) axially flared toward the front opening (78).

4. The fixing wedge (18) according to any one of the preceding claims, **characterized in that** the first and second walls (50, 52) have centering pads (87) parallel to the inner edges (66) and configured to cooperate without play with a mounting rail (40).

5. The fixing wedge (18) according to any one of the preceding claims, **characterized in that** the front opening (78) is able to deform elastically in a direction orthoradial to the main axis (A72).

6. The fixing wedge (18) according to any one of the preceding claims, **characterized in that** the fixing wedge is made in a single piece from a synthetic material, preferably non-filled polyamide.

7. An electrical cabinet (2) comprising an armature (4), **characterized in that** the cabinet comprises at least one fixing wedge (18) according to any one of the preceding claims and a fixing member (16), the fixing member comprising a shaft (24, 112) and a cylindrical radial protuberance (30, 102, 110) coaxially connected to the shaft, wherein the shaft cooperates with the rounded base (70) of at least one of the U-shaped notches (62, 64) of the first or the second wall (50, 52), while the cylindrical radial protuberance cooperates with the central housing (84).

8. The electrical cabinet (2) according to claim 7, **characterized in that** the electrical cabinet comprises at least one panel (6) with an outer face (36), an inner face (38) and an orifice (34) connecting the inner face to the outer face,
wherein the fixing member (16) is a screw (20), the screw including a head (22) and a threaded shaft (24), the head having a shoulder (28) on the side of the shaft, the cylindrical radial protuberance being a collar (30) arranged coaxially on the shaft between the head and the end of the shaft, the orifice (34) of the panel having a diameter larger than the diameter (D30) of the collar (30) and smaller than the diameter of the head (22) of the screw, the panel (6) being attached on this armature (4) using the screw, the head (22) of the screw being located on the side of the outer face (36) of the panel, the wedge (18) being in the assembled configuration (P2) on the collar (30) on the side of the inner face (38) of the panel, and the shaft (24) of the screw passing through the orifice (34) of the panel and being screwed in the armature (4).

9. The electrical cabinet (2) according to claim 7, **characterized in that** the armature (4) comprises at least one crosspiece (12) with a bore (106), a mounting rail (40) with a bottom (92) and two side walls (96), the mounting rail defining an outer side (93) and an inner side (94), a second orifice (100) being arranged in the bottom (92), in which the fixing member (16) is a screw (44) including a head (102) with a diameter (D102) and a threaded shaft, the cylindrical radial protuberance of the fixing member (16) being the head of the screw, the second orifice (100) having a diameter larger than the diameter (D102) of the head of the screw, the mounting rail (40) being attached on the crosspiece (12) using the screw (44), the shaft of which passes through the second orifice of the mounting rail and is screwed into the bore (106) of the crosspiece (12), the wedge (18) being in the assembled configuration (P2) on the head (102) of the screw, one of the first or second walls (50, 52) of the wedge bearing on the inner side (94) of the bottom (92) of the mounting rail while the outer side (93) of the bottom (92) of the rail bears on the crosspiece, the centering pads (87) cooperating with the two side walls (96) of the mounting rail (40).

10. The electrical cabinet (2) according to claim 7, **characterized in that** the electrical cabinet comprises at least one panel (6), attached on this armature (4) and having an inner face (38), a mounting rail (40) with a bottom (92) and two side walls (96), defining an outer side (93) and an inner side (94), a second orifice (100) being arranged in the bottom (92) of the mounting rail,
wherein the fixing member (16) is a pilot point (48) comprising a shaft (112), a base (114) and a head (110), the cylindrical radial protuberance of the fixing member (16) being the head (110) of the pilot point, the base of the pilot point being welded to the inner face (38) of the panel, the second orifice (100) having a diameter larger than the diameter (D110) of the head (110) of the pilot point, the shaft (112) of the pilot point passing through the second orifice of the mounting rail, the wedge (18) being in the assembled configuration (P2) on the head of the pilot point, one of the first or second walls (52, 54) of the wedge bearing on the inner side (94) of the bottom (92) of the mounting rail while the outer side (93) of the bottom of the rail bears on the inner face (36) of the panel (6), the centering pads (87) cooperating with the two side walls (96) of the mounting rail.
